# FASCICULE DE BREVET EUROPEEN

(11) **EP 2 339 623 B1**
(45) Date de publication et mention de la délivrance du brevet: **18.02.2015**
(21) Numéro de dépôt: 10306168.5
(22) Date de dépôt: 26.10.2010
(51) Int. Cl.: H01L 23/498

(54) **Procédé de réalisation d'un élément non plan**
Methode zur Herstellung eines unebenen Elementes
method for producing a non-planar element

(30) Priorité: 22.12.2009 FR 0959341
(43) Date de publication de la demande: 29.06.2011
(73) Titulaire: Commissariat à l'Énergie Atomique et aux Énergies Alternatives, 75015 Paris (FR)
(72) Inventeur: Lasfargues, Gilles, 38000, Grenoble (FR); Dumas, Delphine, 31860, Villate (FR); Fendler, Manuel, 38000, Grenoble (FR)
(74) Mandataire: Vuillermoz, Bruno

(56) Documents cités:
- JP-A- 2003 188 366
- US-A1- 2009 045 510
- US-B1- 6 791 072

## Description

### DOMAINE DE L'INVENTION

La présente invention a trait à la réalisation d'éléments non plans, notamment des composants électroniques ou optiques. Elle trouve particulièrement application dans le domaine des capteurs d'images.

Un procédé selon l'état de la technique antérieure est décrit dans le document US2009/0045510.

### ETAT DE LA TECHNIQUE

Les imageurs électroniques comprennent usuellement un capteur d'image plan semiconducteur réalisé en silicium selon la technologie CMOS ou CCD, et une optique qui forme une image de la scène observée sur le capteur d'image.

Toutefois, l'utilisation d'une simple lentille convergente en tant qu'optique n'est pas satisfaisante dans la mesure où l'image formée par une telle lentille n'est pas plane mais sphérique, phénomène connu sous le nom de « courbure de champ ». De fait, l'image projetée par une lentille convergente sur un capteur plan est soit nette au centre mais pas sur les bords ou l'inverse. Ceci explique notamment la fabrication d'optiques complexes, formées de groupe de lentilles, ayant en outre subi des traitements de surface spécifiques afin de conformer les images qu'elles produisent au caractère plan du capteur.

Cependant, même à l'heure actuelle, les optiques les plus complexes introduisent toujours un certain nombre d'aberrations, tant géométriques que chromatiques, au rang desquelles figurent les distorsions en barillet et en coussinet, les aberrations sphériques (ou aberrations dites de « lumière diffuse »), le coma, l'astigmatisme, le vignettage, les éblouissements, la lumière parasite (reflet), ou encore les franges chromatiques.

De telles aberrations nécessitent d'être corrigées, directement lors de la formation des images par l'utilisation d'optiques complexes et encombrantes, et/ou a posteriori par la mise en oeuvre d'algorithmes de traitement d'images nécessitant d'importantes puissances de calcul. Ainsi, la nature plane des capteurs induit directement des aberrations et la correction de celles-ci implique des objectifs encombrants et couteux ainsi que des calculateurs puissants embarqués dans les caméras et les appareils photographiques numériques.

Une manière efficace de faire disparaître les erreurs induites par la courbure de champ est de modifier la forme du capteur d'image de façon à ce qu'il soit sensiblement de même forme que l'image formée par l'optique. Le fait de pouvoir courber le capteur permet donc, non seulement de corriger les aberrations, mais également de concevoir des caméras et des appareils photographiques compacts et bon marché et ne nécessitant pas de grandes puissances de calcul, le tout accompagnée d'une acuité visuelle augmentée pouvant aller jusqu'au 180° pour les objectifs de type « fish-eye ».

On conçoit donc aisément l'intérêt de concevoir des capteurs courbés dans le domaine de la formation d'image.

Usuellement, les capteurs numériques, quelle que soit leur technologie (CCD ou CMOS pour le visible, à base de CdHgTe pour l'infrarouge, etc...), et leur configuration (monolithique, hybridé, etc...) comprennent un substrat dans lequel est formé un circuit de lecture des pixels, ce substrat présentant une épaisseur de quelques dizaines de micromètres à plusieurs millimètres.

Or, la réalisation d'un substrat courbé, ou plus généralement la réalisation d'un circuit souple, restent difficile pour de telles épaisseurs.

En effet, courber un circuit plan présentant une épaisseur élevée (typiquement supérieure à 50 micromètres), et ayant donc une rigidité élevée, provoque des défauts nuisant à la qualité du circuit, comme par exemple des bourrelets, des fêlures, des déchirures, voire même la destruction de connexions et de composants électriques contenus dans le circuit.

Pour éviter de tels inconvénients, il est possible de concevoir un circuit ayant une épaisseur très faible (typiquement inférieure à 50 micromètres pour un circuit en silicium), et par conséquent une grande souplesse, puis de coller celui-ci sur un support plus rigide présentant la courbure souhaitée.

Toutefois, la colle présente souvent des défauts (bulles, inhomogénéités...) non contrôlables et non prévisibles qui se reportent sur le circuit aminci du fait de la faible épaisseur de ce dernier. La qualité finale du circuit est ainsi en grande partie aléatoire.

En outre, le collage sur une surface courbée est difficile car il est souhaitable de ne pas trop presser le circuit au risque de l'endommager, et d'autant plus difficile que ladite surface présente de nombreuses variations. Usuellement donc, le collage se restreint à une surface plane ou légèrement convexe.

### EXPOSE DE L'INVENTION

Le but de la présente invention est de proposer un procédé de réalisation d'un élément non plan permettant de modeler directement une surface non plane de celui-ci, même complexe, sur un support rigide.

A cet effet, l'invention a pour objet la réalisation d'un élément non plan, qui, selon l'invention, comprend :
■ l'agencement d'un composant souple sur un support au moyen de colonnes d'hybridation, chaque colonne présentant une première hauteur et comprenant un volume de matériau de soudure formé entre deux surfaces mouillables par ledit matériau et entourées de zones non mouillables par celui-ci, les surfaces mouillables et le volume de matériau de soudure étant déterminés en fonction d'une seconde hauteur souhaitée pour le composant souple par rapport au support à l'endroit où est formée la colonne, de manière à ce que la colonne varie de la première hauteur à la seconde hauteur lorsque le volume de matériau est porté à une température supérieure ou égale à sa température de fusion ; et
■ le chauffage des volumes de matériau de soudure des colonnes à une température supérieure ou égale à la température de fusion dudit matériau de manière à faire fondre celui-ci.

En d'autres termes, la technologie d'hybridation dite « *flip-chip* » est détournée de son utilisation initiale qui consiste à interconnecter deux éléments plans entre eux.

Ainsi, le composant souple, comme par exemple un circuit de détection aminci, repose et est fixé sur des colonnes comprenant des moyens de réglage de leur hauteur, à savoir les surfaces mouillables et les volumes de matériau de soudure.

En faisant varier la hauteur des colonnes sur lequel le composant souple repose et auxquelles il est soudé, ce dernier est alors déformé pour prendre le profil de surface souhaité par l'utilisateur. Non seulement, le composant souple est associé, via les colonnes, directement à un support qui peut être rigide, mais en outre, il est possible de créer simplement et de manière reproductible des surfaces non planes complexes en choisissant de manière approprié la hauteur des colonnes.

Par composant « souple », on entend ici un composant qui est capable de se déformer sous l'action de la variation de la hauteur des colonnes. En pratique par exemple, cette souplesse résulte de l'épaisseur du composant, et s'agissant du silicium, ce composant est d'une épaisseur maximum de 50 micromètres.

Selon un premier mode de réalisation de l'invention, le procédé comprend la formation d'un composant épais et rigide destiné à devenir le composant souple par amincissement, et l'agencement du composant souple sur le support comprend :
■ la formation des surfaces mouillables du support et la formation des volumes de matériau de soudure sur lesdites surfaces mouillables du support ;
■ la formation des surfaces mouillables déterminées pour le composant souple sur le composant épais et rigide ;
■ le report du composant épais sur le support de manière à former les colonnes d'hybridation ;
■ le chauffage des volumes de matériau de soudure à une température supérieure ou égale à la température de fusion desdits volumes, suivi du refroidissement de ceux-ci ; et
■ la réalisation du composant souple par amincissement du composant épais et rigide.

En d'autres termes, le composant souple n'est jamais manipulé seul mais toujours fixé à un support. L'élément peut donc être manipulé de manière aisée sans risquer de l'endommager. Il n'est ainsi pas nécessaire de prévoir des dispositifs spéciaux de manipulation usuellement très onéreux.

Dans un second mode de réalisation de l'invention, l'agencement du composant souple sur le support comprend :
■ la formation des surfaces mouillables du support et la formation des volumes de matériau de soudure sur lesdites surfaces mouillables du support ;
■ la formation des surfaces mouillables du composant souple; et
■ le report du composant souple sur le support de manière à former les colonnes d'hybridation.

En d'autres termes, ce mode de réalisation correspond à la technique d'hybridation « flip-chip » dans sa forme classique.

Selon un mode de réalisation de l'invention, les plots ou surfaces mouillables formés sur le support et les volumes de matériau de soudure formés sur lesdits plots forment des éléments de colonne ayant sensiblement la même hauteur de manière à former un plan d'hybridation.

Ceci permet notamment d'utiliser un composant dont on souhaite modeler la surface initialement plane et ainsi de pouvoir utiliser les techniques usuelles en microélectronique (amincissement, traitement de surface, etc...).

Selon une variante de l'invention, les volumes de matériau de soudure sont déposés au moins partiellement sur les surfaces mouillables formées sur le support sous la forme de galettes.

Notamment, lorsqu'un plan d'hybridation est recherché, les galettes permettent de former directement par dépôt et sans fusion du matériau de soudure, des éléments de colonnes présentant sensiblement la même hauteur, et cela même si les volumes de matériau sont différents ou que les surfaces mouillables du support sont réalisées sous la forme de plots de hauteurs et/ou d'aires différentes.

Selon une variante de l'invention, les volumes de matériau de soudure sont déposés sur les surfaces mouillables formées sur le support, chauffés à une température supérieure ou égale à leur température de fusion de manière à former des billes de soudure sur les surfaces mouillables, puis refroidis.

Plus particulièrement, les surfaces mouillables du support ont sensiblement une même aire et sont formées sur des éléments sensiblement de même hauteur, et en ce que les volumes de matériau de soudure sont sensiblement identiques..

Préférentiellement, le matériau de soudure est de l'indium.

L'invention concerne également un détecteur matriciel et un miroir non plans réalisés à l'aide du procédé suscité.

### BREVE DESCRIPTION DES FIGURES

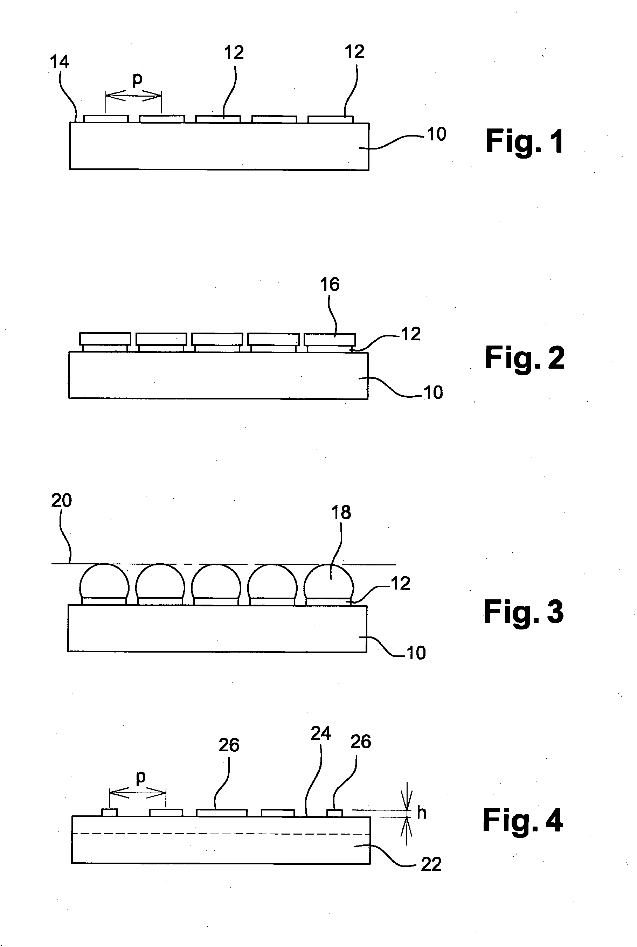

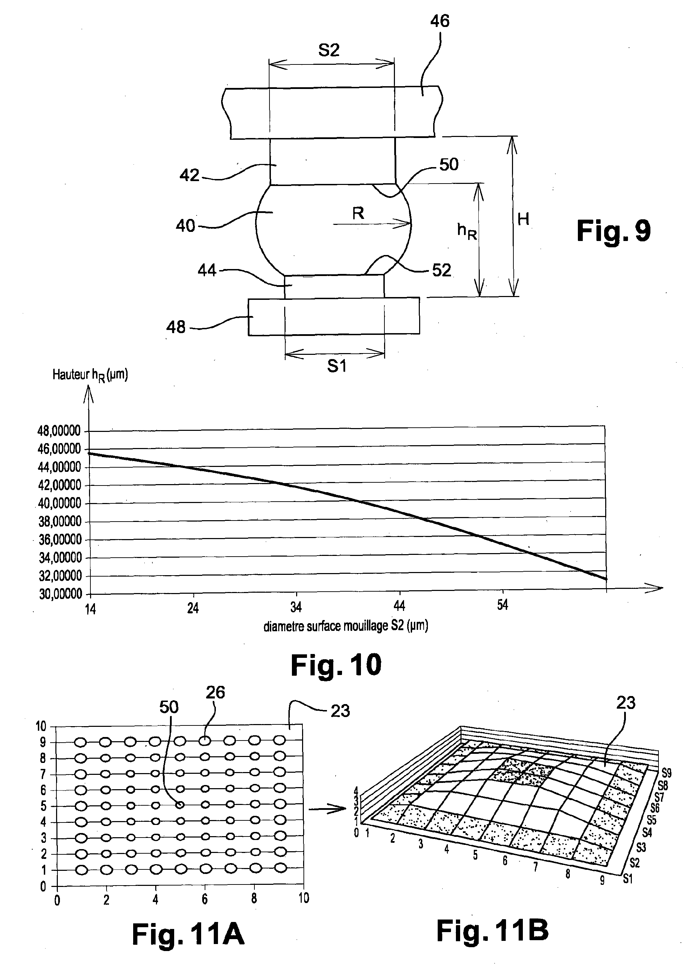

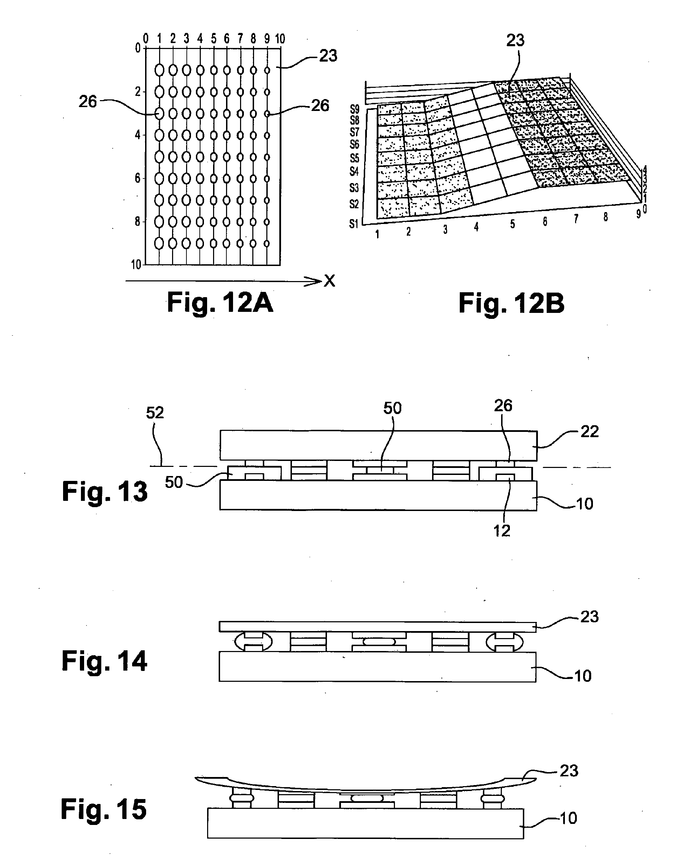

L'invention sera mieux comprise à la lecture de la description qui suit, donnée uniquement à titre d'exemple, et réalisée en relation avec les dessins annexés, dans lesquels des références identiques désignent des éléments identiques ou fonctionnellement analogues, et dans lesquels :
■ les figures 1 à 8 sont des vues en coupe d'un élément lors de différentes étapes du procédé selon un premier mode de réalisation de l'invention ;
■ la figure 9 est une vue en couple plus en détail d'une colonne d'hybridation illustrant le principe physique fondateur de l'invention ;
■ la figure 10 est un tracé illustrant la hauteur d'une colonne d'hybridation en fonction du diamètre d'une zone mouillable ;
■ les figures 11A et 11B sont respectivement une vue de dessous d'un composant à conformer montrant un premier exemple de zones mouillables réalisées et la forme dudit composant une fois la hauteur de colonnes d'hybridation réglée ;
■ les figures 12A et 12B sont respectivement une vue de dessous d'un composant à conformer illustrant un second exemple de zones mouillables réalisées et la forme dudit composant une fois la hauteur des colonnes d'hybridation réglée ; et
■ les figures 13 à 15 sont des vues en coupe d'un élément lors de différentes étapes d'un procédé selon un second mode de réalisation de l'invention.

### DESCRIPTION DETAILLEE DE L'INVENTION

Il va à présent être décrit un procédé selon un premier mode de réalisation selon l'invention.

Ce procédé débute (figure 1) par la formation d'un support plan rigide **10** comportant une matrice de plots cylindriques identiques **12** et régulièrement espacés selon un pas *p*.

Les plots **12** sont formés en un matériau mouillable pour un matériau de soudure ultérieurement déposé, alors que la surface **14** du support **10** sur laquelle ils sont formés est non mouillable pour ledit matériau de soudure.

Le procédé se poursuit (figure 2) par le dépôt de galettes de matériau de soudure **16**, cylindriques et identiques, sur les plots **12**.

L'ensemble est alors porté à une température supérieure ou égale à la température de fusion du matériau des galettes **16** de manière à fondre celle-ci. Du fait de la non mouillabilité du matériau de soudure avec la surface **14** et de la mouillabilité du matériau de soudure avec les plots **12**, le matériau de soudure mouille la surface des plots **12** en prenant la forme de sphères tronquées **18**, usuellement désignées sous l'expression de « billes de soudure » (figure 3). Le chauffage est ensuite stoppé et les billes de soudures **18** se solidifient en se soudant aux plots **12**.

Les plots **12** étant identiques et le volume *V* de matériau de soudure étant identique pour les billes de soudure **18**, le sommet de ces dernières sont disposés sur un même plan **20**, dit « plan d'hybridation ».

Ensuite, ou parallèlement aux étapes susmentionnées, un composant plan **22**, épais et rigide, est muni, sur une surface **24** non mouillable par le matériau des billes de soudure **18**, de plots cylindriques **26** en matériau mouillable par le matériau de soudure. Les plots **26** présentent une hauteur *h* identique et sont formés selon le même schéma de répartition que les plots **12** du support **10**. Les plots **26** sont par conséquent régulièrement espacés selon le pas *p* dans l'exemple illustré. L'aire de chaque plot **26** est quant à elle choisie en fonction d'une hauteur souhaitée, comme cela sera expliqué plus en détail par la suite.

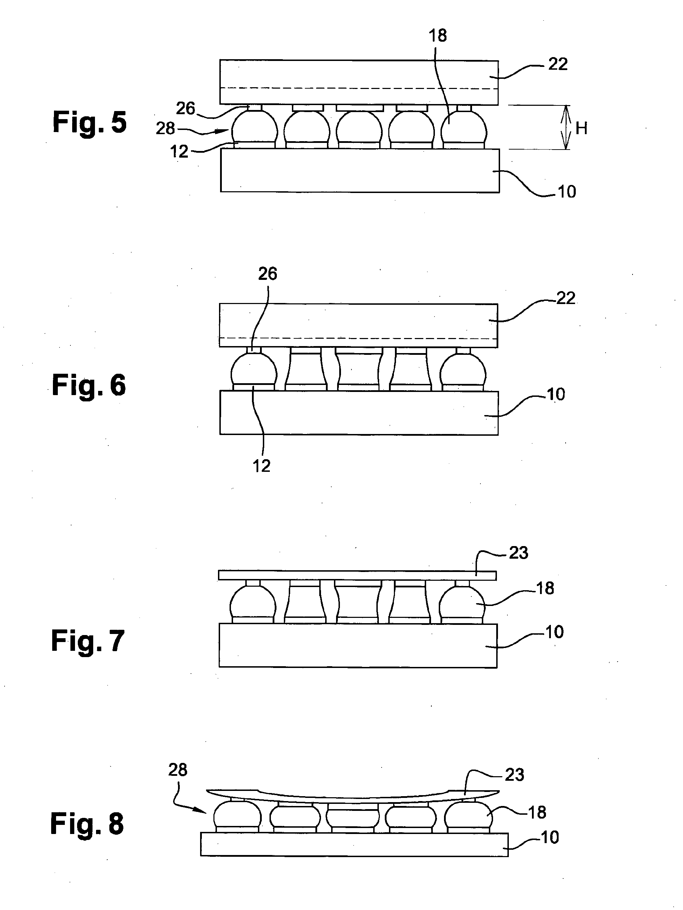

Le composant **22** est ensuite retourné et posé sur les billes de soudure **18** avec les plots **26** positionnés sur ces dernières (figure 5). Des colonnes d'hybridation **28** sont ainsi obtenues comprenant chacune une bille de soudure **18** prise en sandwich entre un plot **12** du support **10** et un plot **26** du composant **22**. Dans l'exemple illustré, du fait du choix particulier des hauteurs des plots **12**, **26** et du volume de matériau identique *V*, les colonnes d'hybridation **28** sont de hauteur *H* identique.

L'ensemble est alors porté à une température supérieure à la température de fusion du matériau des billes de soudure **18** de manière à faire fondre celles-ci, aucune pression n'étant par ailleurs exercée sur le composant **22**. Le matériau de soudure en phase liquide mouille alors les plots **26** du composant **22**.

Le support **10** et le composant **22** étant rigides, les billes de soudure **18** vont soit s'étirer, soit se compresser en fonction de l'aire des plots **12** et **26**.

La figure 9 illustre ce phénomène, ainsi que le principe fondant la présente invention. On considère ici une unique bille de soudure liquide **40** prise en sandwich entre deux plots cylindriques **42**, **44** en matériau mouillable par le matériau de la bille **40** et formés respectivement sur des composants **46**, **48** dont la surface est non mouillable par le matériau de la bille **40**.

Si la hauteur *H* entre les composants **46** et **48** est libre de varier en fonction des propriétés de la bille **40** (par exemple, le composant **48** est fixe et le composant **46** est posé sur la bille **40** sans aucune autre contrainte extérieure), lorsque le matériau de la bille **40** est en phase liquide, celle-ci prend alors une forme d'équilibre unique dépendant de la nature du matériau la constituant, de sa limite de compression (qui détermine la hauteur minimale de la bille **40** à la limite de sa rupture lorsqu'elle est écrasée), de sa limite de tension (qui détermine la hauteur maximum de la bille **40** à la limite de sa rupture lorsqu'elle est étirée) et de paramètres extérieurs tels que la pression exercée par les surfaces avec lesquelles elle est en contact (dans l'exemple illustré, la pression surfacique exercée par le plot **42** du fait de poids du plots **42** et du poids du composant **46**).

On notera également qu'il importe peu que les plots **42**, **44** soient initialement positionnés l'un en face de l'autre avec précision. En effet, lors de la fusion de la bille **40**, l'accrochage du matériau de celle-ci avec les surfaces mouillables des plots **42**, **44** provoque naturellement le déplacement relatif des composants **46**, **48** pour parvenir à un état d'équilibre dans lequel les plots **42**, **44**, et donc les composants **46**, **48**, sont alignés.

De manière pratique, cela signifie qu'il est possible de positionner grossièrement les plots **26** sur les billes **18** lors de l'étape décrite à la figure 5, la fusion ultérieure des billes **18** provoquant un auto-alignement du composant **22** sur le support **10**.

En pratique toujours, si la pression due au poids du plot **42** et du composant **46** est négligeable (comme cela est le cas des circuits microélectroniques qui reposent sur une multitude de colonnes d'hybridation), la forme d'équilibre de la bille **40** s'approxime par une sphère tronquée par les surfaces **50**, **52**. Cette sphère tronquée présente une hauteur d'équilibre *h_{R}* aisément calculable par de simples règles de calcul géométrique en fonction du volume de matériau de la bille **40** et de l'aire *S₁, S ₂* des surfaces **50**, **52** des plots **42**, **44**.

Notamment, on notera que plus la somme des aires *S ₁, S₂* est importante, plus la hauteur d'équilibre *h_{R}* est réduite.

Si par contre la hauteur *H* entre les composants **46** et **48** est contrainte d'une quelconque manière, la bille **40** s'étire si cette hauteur *H* est supérieure à la hauteur d'équilibre *h_{R}* ou se comprime si cette hauteur *H* est inférieure à la hauteur d'équilibre *h_{R}*.

En se référant de nouveau à la figure 6, on comprend alors que les billes **18** en contact avec des plots **12**, **26** de grande surface mouillable vont tirer le composant **22** vers le support **10**. Ce rapprochement est cependant bloqué par les billes **18** en contact avec des plots **12**, **26** de petite surface mouillable car ces billes atteignent leur limite de compression. Le composant **22** étant rigide, et donc non déformable, il impose ainsi aux billes **18** sous forme liquide un forme étirée ou compressée en fonction de la surface des plots **12**, **26** qui déterminent les hauteurs d'équilibre des billes **18**. Un état d'équilibre est alors obtenu pour l'ensemble.

Le chauffage est stoppé de manière à rendre les billes **18** solides, le composant **22** étant ainsi soudé au support **10** via les colonnes d'hybridation **28**. On comprendra que cet état est intermédiaire et que la forme des billes de soudure, étirées ou compressées, ainsi que la hauteur séparant le composant **22** du support **10** importent peu à ce stade du procédé, le tout étant d'obtenir un ensemble rigide capable de subir des techniques classiques du domaine, et notamment des techniques d'amincissement et/ou de traitement de surface.

Une fois les billes de soudure **18** solidifiées, le procédé se poursuit (figure 7) par l'amincissement du composant **22** pour lui conférer un caractère souple, c'est-à-dire suffisamment déformable pour permettre aux billes **18** de prendre leur forme d'équilibre une fois à l'état liquide. Par exemple un rodage ou un polissage mécanique est utilisé. Un composant souple **23** est ainsi obtenu. Par exemple un composant en silicium aminci pour présenter une épaisseur inférieure à 50 micromètres peut voir sa hauteur varier de plus de 20% sans détérioration notable.

Une fois le composant souple **23** formé par amincissement, l'ensemble est à nouveau chauffé à une température supérieure ou égale à la température de fusion du matériau des billes de soudure **18** (figure 8). Le composant **23** étant souple, il autorise alors les billes de soudure **18** à prendre leur forme d'équilibre. Le composant **23** est alors déformé conformément aux hauteurs des colonnes d'hybridation **28**, elles mêmes déterminées par les hauteurs d'équilibre *h_{R}* des billes **18**.

Le chauffage est alors stoppé pour solidifier les billes de soudure **18** dans leur forme d'équilibre. Il est ainsi obtenu un composant **23** présentant une surface non plane modelée par les colonnes d'hybridation **28** de hauteurs différentes et solidarisé par soudure à un support rigide.

Le tracé de la figure 10 illustre la hauteur d'équilibre des billes de soudure **18** pour des plots **12** du support **10** de diamètre égal à 45,17 micromètres (soit une aire *S₁* de 1,602.10³ µm²) et un volume de matériau des billes **18** égal à 86,023.10³ µm³. En abscisses, il est représenté le diamètre des plots **26** formés sur le composant **23** et en ordonnées la hauteur d'équilibre *h_{R}* correspondante des billes **18**.

Comme on peut le constater, il est possible d'obtenir par un choix approprié du diamètre des plots **26**, et donc de l'aire de la surface mouillable définie par les plots **26**, une variation de 60 % de la hauteur d'équilibre des billes **18**, ce qui est suffisant pour modeler un composant **22** en silicium d'une épaisseur inférieure à 50 micromètres pouvant subir une variation de 20% de sa hauteur sans dégradation.

La figure 11A illustre une vue de dessous du composant **23** avec un premier exemple de plots **26**. Les plots **26**, et donc les surfaces mouillables par les billes **18**, présentent ici une aire croissante en fonction de la distance à un plot central **50**. Il est ainsi obtenu une surface convexe pour le composant souple **23** telle qu'illustrée à la figure 11B. Une telle surface convexe, et notamment sphérique, convient particulièrement aux détecteurs matriciels comme cela a été décrit précédemment.

La figure 12A illustre une vue de dessous du composant **23** avec un second exemple de plots **26** dont l'aire diminue selon un axe X. Il est ainsi obtenu une surface avec des portions inclinées pour le composant souple **23**, telle qu'illustrée à la figure 12B. Si l'aire des plots **26** diminue de manière constante selon l'axe X, une surface plane inclinée par rapport au support **10** est alors obtenue. Une surface inclinée convient par exemple à des micromiroirs De tels micromiroirs sont notamment intéressants pour la réflexion de faisceaux laser selon un angle contrôlé.

Le matériau des billes de soudure **18** est préférentiellement choisi parmi métaux et alliages à bas point de fusion pour ne pas endommager le support **10** et le composant **23** lors des chauffages, notamment l'étain, l'indium et le plomb et les alliages à base de ceux-ci.

L'indium est préférentiellement utilisé par sa température basse de fusion de 156,6°C. Les plots **12**, **26**, ou une couche superficielle de ceux-ci, sont alors constitués d'or et les surfaces non mouillable entourant les plots **12**, **26** sont constitués d'un isolant tel que la silice ou un polyimide. Par exemple, le support est constitué d'un tel matériau ou comprend une couche superficielle constituée d'un tel matériau.

Il a été décrit un procédé dans lequel le composant **22** épais et rigide est hybridé sur le support **10** au moyen des colonnes d'hybridation, ce qui permet notamment de ne pas avoir à manipuler de composant souple seul et donc de prévoir des dispositifs de manipulation spécifique.

En variante, le composant souple **23** est directement hybridé sur le support **10**. Dans un tel cas, une seule étape de chauffage suffit à modeler la surface du composant. L'avantage de ce mode de réalisation est de pouvoir augmenter la déformation maximum accessible avec des billes d'indium en choisissant, en cas de besoin, des surfaces mouillables différentes pour le support et des volumes de matériau différents. On dispose ainsi de trois degrés de liberté pour régler la hauteur d'équilibre des billes de soudure.

Il a été également décrit un procédé dans lequel les plots **12** du support **10** ont une surface de mouillabilité identique, le réglage de la hauteur des colonnes d'hybridation **18** se faisant par l'aire des surfaces des plots **26** du composant **23**. Ceci permet notamment, lorsque le volume des billes de soudure **18** est identique, d'obtenir un plan d'hybridation, ce qui facilite le procédé dans la mesure où les dispositifs classiques utilisés fonctionnent avec des plans parallèles. Toutefois, cela limite la variabilité de la hauteur des billes de soudure **18** et donc des colonnes d'hybridation **28**.

En variante, les plots **12** du support **10** présentent également des surfaces de mouillabilité différentes. La gamme de hauteurs possibles pour les billes de soudure **18** est ainsi étendue. De même, le volume de matériau pour les billes de soudure **18** peut être différent d'une bille à l'autre afin d'augmenter ladite gamme. De même les hauteurs des plots **12** du support **10** et/ou les hauteurs des plots **26** du composant **23** peuvent être choisies différentes pour étendre la gamme de hauteurs possibles pour les colonnes d'hybridation **28**. De même, les surfaces de mouillabilité peuvent être réalisées directement dans les surfaces du support **10** et du composant **23**, par exemple par gravure.

On notera que la forme des surfaces mouillables, et donc des plots dans les modes de réalisation décrits, peut être quelconque et choisie en fonction de l'application visée. On notera à cet égard, que la sphère tronqué reste valable comme première approximation de calcul pour la hauteur d'équilibre, quelque soit la forme des surface mouillable

On notera également que les colonnes d'hybridation peuvent également avoir la fonction classique d'interconnexions électriques entre le composant **22**, par exemple un circuit de détection comportant une matrice d'éléments unitaires de détection, et le support **10**, par exemple un circuit de lecture de la matrice des éléments unitaires de détection.

Il a été décrit des modes de réalisation dans lequel le report du composant épais et rigide **22** ou du composant souple **23** est réalisé une fois les billes de soudure **18** mise en forme une première fois, tel que cela est décrit en relation avec la figure 3. Dans un second mode de réalisation, dont une variante est illustrée aux figures 13 à 15, le report du composant épais et rigide **22** est réalisé directement sur les galettes de matériau de fusion déposées sur les surfaces de mouillabilité du support **10** non mouillable. Ceci permet notamment d'utiliser, au besoin, aisément des volumes différents pour les billes de soudure tout en réalisant un plan d'hybridation.

En se référant à la figure 13, des galettes de matériau de soudure **50** sont déposées sur les plots **12** du support **10** de manière à obtenir un plan d'hybridation **52.** En fonction du volume de matériau de soudure d'une galette **50** déposée sur un plot **12**, la galette **50** peut entièrement couvrir le plot **12**, voire même le noyer. Le composant épais et rigide **22** est alors posé sur les galettes **50** sans étape préalable de mise en forme des galettes **50** par chauffage.

L'ensemble est alors chauffé pour faire fondre le matériau de soudure des galettes, refroidi pour solidifier celles-ci, de sorte que le composant **22** est soudé au composant **10**. Le composant **22** est aminci pour le rendre souple (figure 14). Enfin, l'ensemble est chauffé pour faire fondre les différents volumes de matériau soudure qui prennent alors leur forme d'équilibre en modelant ainsi le composant souple **23** assoupli (figure 15), puis l'ensemble est refroidi.

Grâce à l'invention, il est ainsi obtenu les avantages suivants :
■ le modelage d'une surface réalisée directement par rapport à un support rigide plan ;
■ la réalisation de surfaces complexes à l'aide d'un procédé faisant appel à des techniques classiques, tel que le dépôt de matériau et la fusion de matériau ;
■ une intégration aisée dans les procédés classiques de fabrication de composants microélectroniques réalisés par hybridation « flip-chip » ;
■ une répétabilité accrue d'une surface particulière, quelle que soit cette forme, du fait de la propension naturelle d'une bille de soudure à présenter le même volume d'équilibre à environnement constant ;
■ une compensation de l'effet bilame du composant une fois refroidi. Notamment, lorsqu'un composant hétérogène (assemblage de deux composants plans) est mis a une température différente de sa température d'assemblage ; il existe une différence entre deux coefficient de dilatation qui a pour effet de courber le composant. En connaissant la courbure de ce composant à basse température, on peut la minimiser celle-ci en modelant un composant avec sa courbure contraire

## Revendications

1. Procédé de réalisation d'un élément non plan, comprenant
▪ l'agencement d'un composant souple (23) sur un support (10) au moyen de colonnes d'hybridation (28), chaque colonne (28) présentant une première hauteur et comprenant un volume de matériau de soudure (18 ; 50) formé entre deux surfaces mouillables (12, 26) par ledit matériau de soudure rapportées respectivement sur le composant souple (23) et sur le support (10), lesdites surfaces mouillables étant entourées de zones non mouillables (14, 24) par le matériau de soudure, les surfaces mouillables (12, 26) et le volume de matériau de soudure (18 ;50) étant déterminés en fonction d'une seconde hauteur souhaitée pour le composant souple (23) par rapport au support (10) à l'endroit où est formée la colonne, de manière à ce que la colonne (28) varie de la première hauteur à la seconde hauteur lorsque le volume de matériau (18 ; 50) est porté à une température supérieure ou égale à sa température de fusion ;
**caractérisé en ce qu'**il comprend
▪ le chauffage des volumes de matériau de soudure (18 ; 50) des colonnes (28) à une température supérieure ou égale à la température de fusion dudit matériau de manière à faire fondre celui-ci.

2. Procédé de réalisation d'un élément non plan selon la revendication 1, ***caractérisé* en ce qu'**il comprend la formation d'un composant épais et rigide (22) destiné à devenir le composant souple (23) par amincissement, et **en ce que** l'agencement du composant souple (23) sur le support (10) comprend :
▪ la formation des surfaces mouillables (12) du support (10) et la formation des volumes de matériau de soudure (18) sur lesdites surfaces mouillables (12) du support (10) ;
▪ la formation des surfaces mouillables (26) déterminées pour le composant souple (23) sur le composant épais (22) ;
▪ le report du composant épais et rigide (22) sur le support (10) avec mise en contact des surfaces mouillables (26) et des volumes de matériau de soudure (18) de manière à former les colonnes d'hybridation (28) ;
▪ le chauffage des volumes de matériau de soudure à une température supérieure ou égale à la température de fusion desdits volumes, suivi du refroidissement de ceux-ci ; et
▪ la réalisation du composant souple (23) par amincissement du composant épais et rigide (22).

3. Procédé de réalisation d'un élément non plan selon la revendication 1, ***caractérisé* en ce que** l'agencement du composant souple (23) sur le support (10) comprend :
▪ la formation des surfaces mouillables (12) du support (10) et la formation des volumes de matériau de soudure (18 ; 50) sur lesdites surfaces mouillables (12) du support (10) ;
▪ la formation des surfaces mouillables (26) du composant souple (23) ; et
▪ le report du composant souple (23) sur le support (10) avec mise en contact des surfaces mouillables (12) et des volumes de matériau de soudure (18 ; 50) de manière à former les colonnes d'hybridation.

4. Procédé de réalisation d'un élément non plan selon la revendication 2 ou 3, *caractérisé* en ce les surfaces mouillables (12) formées sur le support (10) et les volumes de matériau de soudure (18 : 50) formés sur lesdites surfaces mouillables (12) forment des éléments de colonne ayant sensiblement la même hauteur de manière à former un plan d'hybridation (20).

5. Procédé de réalisation d'un élément non plan selon l'une des revendications 2, 3 ou 4, ***caractérisé* en ce que** les volumes de matériau de soudure (18 ; 50) sont déposés au moins partiellement sur les surfaces mouillables (12) formées sur le support (10) sous la forme de galettes (16 ; 50).

6. Procédé de réalisation d'un élément non plan selon la revendication 2, 3, 4 ou 5, ***caractérisé* en ce que** les volumes de matériau de soudure sont déposés sur les surfaces mouillables (12) formées sur le support (10), chauffés à une température supérieure ou égale à leur température de fusion de manière à former des billes de soudure (18) sur les surfaces mouillables (12), puis refroidis.

7. Procédé de réalisation d'un élément non plan selon les revendications 4 et 6, ***caractérisé* en ce que** les surfaces mouillables (12) du support (10) ont sensiblement une même aire et sont formées sur des éléments sensiblement de même hauteur, et **en ce que** les volumes (18) de matériau de soudure sont sensiblement identiques.

8. Procédé de réalisation d'un élément non plan selon l'une quelconque des revendications précédentes, ***caractérisé* en ce que** le matériau de soudure est de l'indium.

9. Détecteur matriciel non plan réalisé selon un procédé selon l'une quelconque des revendications précédentes.

10. Miroir non plan réalisé selon un procédé selon l'une quelconque des revendications 1 à 8.

## Patentansprüche

1. Verfahren zur Herstellung eines nicht ebenen Elements, Folgendes umfassend:
▪ Anordnen eines nachgiebigen Bestandteils (23) auf einem Träger (10) mittels Hybridisierungssäulen (28), wobei jede Säule (28) eine erste Höhe aufweist und ein Lötmaterialvolumen (18; 50) umfasst, das durch das Lötmaterial zwischen zwei benetzbaren Flächen (12, 26) gebildet ist, die auf den nachgiebigen Bestandteil (23) bzw. auf den Träger (10) aufgebracht sind, wobei die benetzbaren Flächen durch das Lötmaterial von nicht benetzbaren Zonen (14, 24) umgeben sind, wobei die benetzbaren Flächen (12, 26) und das Lötmaterialvolumen (18; 50) in Abhängigkeit von einer zweiten gewünschten Höhe für den nachgiebigen Bestandteil (23) in Bezug auf den Träger (10) an der Stelle, an der die Säule gebildet ist, bestimmt werden, damit sich die Säule (28) von der ersten Höhe auf die zweite Höhe verändert, wenn das Materialvolumen (18; 50) auf eine Temperatur gebracht wird, die höher als seine oder gleich seiner Schmelztemperatur ist;
**dadurch gekennzeichnet, dass** es umfasst:
▪ Erwärmen der Lötmaterialvolumina (18; 50) der Säulen (28) auf eine Temperatur, die höher ist als die oder gleich der Schmelztemperatur des Materials ist, um dieses zu schmelzen.

2. Verfahren zur Herstellung eines nicht ebenen Elements nach Anspruch 1,
**dadurch gekennzeichnet, dass** es die Ausbildung eines dicken und starren Bestandteils (22) umfasst, der dazu bestimmt ist, durch Dickenminderung zum nachgiebigen Bestandteil (23) zu werden, und dass das Anordnen des nachgiebigen Bestandteils (23) auf dem Träger (10) umfasst:
▪ Ausbilden benetzbarer Flächen (12) des Trägers (10) und Ausbilden der Lötmaterialvolumina (18) auf den benetzbaren Flächen (12) des Trägers (10);
▪ Ausbilden bestimmter benetzbarer Flächen (26) für den nachgiebigen Bestandteil (23) auf dem dicken Bestandteil (22);
▪ Verschieben des dicken und starren Bestandteils (22) auf dem Träger (10) mit Herstellung eines Kontakts der benetzbaren Flächen (26) und der Lötmaterialvolumina (18), um die Hybridisierungssäulen (28) zu bilden;
▪ Erwärmen der Lötmaterialvolumina auf eine Temperatur, die höher als die oder gleich der Schmelztemperatur der Volumina ist, gefolgt von deren Abkühlung; und
▪ Herstellen des nachgiebigen Bestandteils (23) durch Dickenminderung des dicken und starren Bestandteils (22).

3. Verfahren zur Herstellung eines nicht ebenen Elements nach Anspruch 1,
**dadurch gekennzeichnet, dass** das Anordnen des nachgiebigen Bestandteils (23) auf dem Träger (10) umfasst:
▪ Ausbilden benetzbarer Flächen (12) des Trägers (10) und Ausbilden der Lötmaterialvolumina (18; 50) auf den benetzbaren Flächen (12) des Trägers (10);
▪ Ausbilden der benetzbaren Flächen (26) des nachgiebigen Bestandteils (23); und
▪ Verschieben des nachgiebigen Bestandteils (23) auf dem Träger (10) mit Herstellung eines Kontakts der benetzbaren Flächen (12) und der Lötmaterialvolumina (18; 50), um die Hybridisierungssäulen zu bilden.

4. Verfahren zur Herstellung eines nicht ebenen Elements nach Anspruch 2 oder 3, **dadurch gekennzeichnet, dass** die benetzbaren Flächen (12), die auf dem Träger (10) ausgebildet sind, und die Lötmaterialvolumina (18; 50), die auf den benetzbaren Flächen (12) ausgebildet sind, Säulenelemente bilden, die im Wesentlichen dieselbe Höhe haben, um eine Hybridisierungsebene (20) zu bilden.

5. Verfahren zur Herstellung eines nicht ebenen Elements nach einem der Ansprüche 2, 3 oder 4, **dadurch gekennzeichnet, dass** die Lötmaterialvolumina (18; 50) zumindest teilweise auf den auf dem Träger (10) ausgebildeten benetzbaren Flächen (12) in Form von Scheiben (16; 50) abgeschieden werden.

6. Verfahren zur Herstellung eines nicht ebenen Elements nach Anspruch 2, 3, 4 oder 5, **dadurch gekennzeichnet, dass** die Lötmaterialvolumina auf den auf dem Träger (10) ausgebildeten benetzbaren Flächen (12) abgeschieden werden, auf eine Temperatur, die höher ist als ihre oder gleich ihrer Schmelztemperatur ist, erwärmt werden, um aus den benetzbaren Flächen (12) Lötkugeln (18) zu bilden, und dann abgekühlt werden.

7. Verfahren zur Herstellung eines nicht ebenen Elements nach den Ansprüche 4 und 6, **dadurch gekennzeichnet, dass** die benetzbaren Flächen (12) des Trägers (10) im Wesentlichen denselben Flächenraum haben und auf den Elementen ausgebildet sind, die im Wesentlichen die gleiche Höhe haben, und dass die Lötmaterialvolumina (18) im Wesentlichen identisch sind.

8. Verfahren zur Herstellung eines nicht ebenen Elements nach einem der vorhergehenden Ansprüche, **dadurch gekennzeichnet, dass** das Lötmaterial Indium ist.

9. Nicht ebener Matrixdetektor, der gemäß einem Verfahren nach einem der vorhergehenden Ansprüche hergestellt ist.

10. Nicht ebener Spiegel, der gemäß einem Verfahren nach einem der Ansprüche 1 bis 8 hergestellt ist.

## Claims

1. Method for producing a non-plane element, comprising: fitting a flexible component (23) on a carrier (10) by means of hybridization columns (28), each column (28) having a first height and including a volume of solder material (18; 50) formed between two surfaces (12, 26) wettable by said solder material added to the flexible component (23) and to the carrier (10) respectively, said wettable surfaces being surrounded by zones (14, 24) non-wettable by the solder material, the wettable surfaces (12, 26) and the volume of solder material (18; 50) being determined as a function of a second height required for the flexible component (23) relative to the carrier (10) at the place where the column is formed, such that the column (28) varies from the first height to the second height when the volume of material (18; 50) is brought to a temperature higher than or equal to its melting point, wherein it further comprises heating the volumes of solder material (18; 50) of the columns (28) to a temperature higher than or equal to the melting point of said material in order to melt it.

2. Method for producing a non-plane element as claimed in claim 1, wherein it includes the formation of a thick and rigid component (22) intended to become the flexible component (23) by thinning down, and wherein fitting the flexible component (23) onto the carrier (10) includes:
▪ forming the wettable surfaces (12) of the carrier (10) and forming the volumes of solder material (18) on said wettable surfaces (12) of the carrier (10);
▪ forming the wettable surfaces (26) determined for the flexible component (23) on the thick component (22);
▪ transferring the thick and rigid component (22) onto the carrier (10) thereby bringing the wettable surfaces (26) and the volumes of solder material (18) into contact so as to form the hybridization columns (28);
▪ heating the volumes of solder material to a temperature higher than or equal to the melting point of said volumes, and then cooling same; and
▪ producing the flexible component (23) by thinning down the thick and rigid component (22).

3. Method for producing a non-plane element as claimed in claim 1, wherein fitting the flexible component (23) onto the carrier (10) includes:
▪ forming the wettable surfaces (12) of the carrier (10) and forming the volumes of solder material (18; 50) on said wettable surfaces (12) of the carrier (10);
▪ forming the wettable surfaces (26) of the flexible component (23); and
▪ transferring the flexible component (23) onto the carrier (10) thereby bringing the wettable surfaces (12) and the volumes of solder material (18; 50) into contact so as to form the hybridization columns.

4. Method for producing a non-plane element as claimed in claim 2 or 3, wherein the wettable surfaces (12) formed on the carrier (10) and the volumes of solder material (18; 50) formed on said wettable surfaces (12) form column elements of substantially the same height so as to form a hybridization plane (20).

5. Method for producing a non-plane element as claimed in any one of claims 2, 3 or 4, wherein the volumes of solder material (18; 50) are deposited at least partially on the wettable surfaces (12) formed on the carrier (10) in the form of wafers (16; 50).

6. Method for producing a non-plane element as claimed in claim 2, 3, 4 or 5, wherein the volumes of solder material are deposited on the wettable surfaces (12) formed on the carrier (10), heated to a temperature higher than or equal to the melting point thereof so as to form solder beads (18) on the wettable surfaces (12), and then cooled.

7. Method for producing a non-plane element as claimed in claims 4 and 6, wherein the wettable surfaces (12) of the carrier (10) have substantially the same area and are formed on elements of substantially the same height, and in that the volumes (18) of solder material are substantially identical.

8. Method for producing a non-plane element as claimed in any one of the previous claims, wherein the solder material is indium.

9. Non-plane matrix detector produced in accordance with a method as claimed in any one of the previous claims.

10. Non-plane mirror produced in accordance with a method as claimed in any one of claims 1 to 8.
